# EUROPÄISCHE PATENTANMELDUNG

(11) **EP 4 700 318 A1**
(43) Veröffentlichungstag der Anmeldung: **25.02.2026**
(21) Anmeldenummer: 24195271.2
(22) Anmeldetag: 20.08.2024
(51) Int. Cl.: F28F 3/04, B21D 13/00, B21D 17/00, B21D 22/00, B21H 8/00, B21J 5/12, B21K 23/00, F28F 3/12

(54) **HERSTELLUNG EINES WÄRMEROHRS**

(71) Anmelder: Siemens Aktiengesellschaft, 80333 München (DE)
(72) Erfinder: Danov, Vladimir, 91056 Erlangen (DE); Dennerlein, Klaus, 91058 Erlangen (DE); Müller, Volker, 90459 Nürnberg (DE); Neugebauer, Stephan, 91058 Erlangen (DE); Schwarz, Florian, 91466 Gerhardshofen (DE); Wohlfart, Manfred, 91369 Wiesenthau (DE)
(74) Vertreter: Siemens Patent Attorneys

(57) **Zusammenfassung**

Es wird ein Verfahren zum Herstellen eines Wärmerohrs (3) mit einem geschlossenen Innenraum (7) zum Transport eines fluiden Arbeitsmediums (9) angegeben,
wobei der Innenraum (7) wenigstens durch ein flächiges Trägerelement (18) und ein dem Trägerelement (18) gegenüberliegendes flächiges Deckelement (17) begrenzt ist,
wobei der Innenraum (7) zumindest teilweise durch eine kanalförmige Ausnehmung (40) des Trägerelements (18) und/oder Deckelements (17) definiert ist,
wobei die kanalförmige Ausnehmung (40) zumindest teilweise durch Anwendung eines Prägeschritts auf einen Rohling des Trägerelements (18) und/oder einen Rohling des Deckelements ausgebildet wird, und wobei nach dem Ausbilden der Ausnehmung (40) das Trägerelement (18) mit dem Deckelement (17) verbunden wird.

Weiterhin wird ein entsprechend hergestelltes Wärmerohr (3) sowie ein Elektronikmodul (1) mit einem solchen Wärmerohr (3) angegeben.

## Beschreibung

Die vorliegende Erfindung betrifft ein Verfahren zum Herstellen eines Wärmrohrs mit einem geschlossenen Innenraum zum Transport eines fluiden Arbeitsmediums, insbesondere in einem selbständig pulsierenden Betrieb, wobei der Innenraum wenigstens durch ein flächiges Trägerelement und ein dem Trägerelement gegenüberliegendes flächiges Deckelement begrenzt ist, und wobei der Innenraum zumindest teilweise durch eine kanalförmige Ausnehmung des Trägerelements definiert ist. Weiterhin betrifft die Erfindung ein mit einem solchen Verfahren hergestelltes Wärmerohr sowie ein entsprechendes Elektronikmodul mit einem solchen Wärmerohr.

Aus dem Stand der Technik sind sogenannte "pulsierende Heatpipes" (PHP) bekannt. Eine PHP ist ein Wärmerohr mit einem geschlossenen Innenraum zum Transport eines fluiden Arbeitsmediums in einem selbständig pulsierenden Betrieb.

Allgemein ist ein Wärmerohr (auch als Heatpipe bezeichnet) ein Wärmeübertrager, der durch die Nutzung der Verdampfungsenthalpie eines fluiden Arbeitsmediums eine hohe Wärmestromdichte erlaubt. Das Arbeitsmedium wird dabei in einem geschlossenen Innenraum (Kavität) in einem geschlossenen Kreislauf zwischen einem Verdampferbereich und einem Kondensatorbereich zirkuliert. Dabei geht das Arbeitsmedium in dem Verdampferbereich unter Aufnahme von Wärme vom flüssigen in den gasförmigen Aggregatzustand über und in dem Kondensatorbereich unter Abgabe von Wärme vom gasförmigen in den flüssigen Aggregatzustand über. Entsprechend ist dem Verdampferbereich ein zu entwärmender Teil des Wärmerohrs zugeordnet, und dem Kondensatorbereich ist ein zu erwärmender Teil des Wärmerohrs zugeordnet. Insgesamt wird also ein Wärmetransport vom Verdampferbereich zum Kondensatorbereich bewirkt. Auf diese Weise können große Wärmemengen auf kleiner Querschnittsfläche übertragen werden. Bei einem konventionellen Wärmerohr erfolgt der Rücktransport von kondensiertem Arbeitsmedium vom Kondensatorbereich zum Verdampferbereich mittels kapillarem Transport durch eine innerhalb der Kavität angeordnete Kapillarstruktur, die auch als Dochtstruktur bezeichnet wird. Ein Wärmerohr kann allgemein beispielsweise als gebogenes Rohr oder auch als flache Platte ausgeführt werden. Das Wort "Wärmerohr" bezeichnet hier also nur ein Wirkprinzip und nicht eine rohrartige Form. Dies gilt auch für das pulsierende Wärmerohr.

Im Unterschied zum konventionellen Wärmerohr wird in einem pulsierenden Wärmerohr der Rücktransport des kondensierten Arbeitsmediums zur Wärmequelle durch ein eigenständiges Pulsieren des Arbeitsmediums bewirkt. Um dies zu ermöglichen, weist der Innenraum des Wärmerohrs eine vergleichsweise enge kanalartige Struktur auf. Mit anderen Worten bildet er einen Medienkanal aus. Dieser Medienkanal ist so eng ausgestaltet, dass sich durch die Oberflächenspannung des kondensierten Arbeitsmediums miteinander abwechselnde und jeweils in sich zusammenhängende Segmente aus Flüssigkeit und Dampf ausbilden. Ein solches "Segment" aus Flüssigkeit oder Dampf erstreckt sich dabei im Wesentlichen über einen Teilabschnitt des länglich geformten Medienkanals, bildet also ein Längssegment aus. Der Medienkanal muss dabei nicht zwangsläufig gerade sein, sondern kann beispielsweise mäanderförmige Windungen aufweisen. Er hat aber vorteilhaft eine insgesamt längliche Form, die in eine Anzahl von Streckenabschnitten (Längssegmenten) unterteilbar ist. An der warmen Seite des Wärmerohrs dehnen sich die Dampfsegmente aus und schrumpfen an der kalten Seite des Wärmerohrs. Dabei kann an der kalten Seite auch eine (ggf. anteilige) Kondensation erfolgen. In der PHP liegen dadurch stets lokale Temperatur- und Druckunterschiede vor, deren Ausgleich das zweiphasige System durch in Längsrichtung verschiebende Kräfte auf die Flüssigkeits- und Dampfsegmente anstrebt. Diese Ausgleichskräfte führen zu einer ständigen pulsierenden Bewegung der einzelnen Segmente, die sich ohne einen aktiven äußeren Antrieb allein durch den Temperaturunterschied und aufgrund der Oberflächenspannung innerhalb des Medienkanals automatisch einstellt. Insbesondere erreicht das System nie ein statisches Gleichgewicht, sondern das Pulsieren wird aufrechterhalten, solange ein Temperaturunterschied besteht und solange eine Aufteilung in abwechselnde Längssegmente aus Flüssigkeit und Dampf vorliegt. Diese Bewegung wird auch als selbst-oszillierende Zweiphasenströmung bezeichnet. Im vorliegenden Zusammenhang wird dabei nicht zwischen einer "oszillierenden" und einer "pulsierenden" Bewegung unterschieden, obwohl mit diesen Begriffen streng genommen ein Unterschied bezüglich der vorherrschenden Transportrichtung assoziiert werden könnte.

Durch die pulsierende Bewegung der Fluidsegmente erfolgt der Transport von (flüssigem und dampfförmigem) Arbeitsmittel zwischen Kondensatorbereich und Verdampferbereich und damit auch der Wärmetransport. Insgesamt können mit einer solchen PHP deutlich geringere Wärmewiderstände erreicht werden als mit einem konventionellen Wärmerohr. Da auf eine innenliegende Kapillarstruktur verzichtet werden kann, ist auch die Fertigung vergleichsweise einfach. Zur Kühlung von elektronischen Bauelementen in Elektronikmodulen ist allgemein eine Ausführung als flachplattige PHP besonders bevorzugt. Einen guten Überblick über die Funktionsweise, die Anwendung und bevorzugte Geometrien solcher PHPs gibt die Dissertation von Florian Schwarz (Florian Schwarz. 2022. Optimierte Pulsierende Heatpipe Designs zur Kühlung von Leistungselektronik. Erlangen: FAU University Press. DOI: 10.25593/978-3-96147-533-9.).

Bei der Herstellung von bekannten PHPs wird typischerweise ein Trägerelement mit einem Deckelement verbunden, nachdem in wenigstens einem dieser beiden Elemente eine kanalförmige Ausnehmung ausgebildet wurde. Der geschlossene Innenraum wird dann durch das Trägerelement und das Deckelement begrenzt. Optional kann dazwischen ein weiteres Zwischenelement (Inlay) eingelegt werden, welches auch solch eine kanalförmige Ausnehmung aufweisen kann und dann ebenfalls den Innenraum des Wärmerohrs begrenzt. Das Befüllen mit dem Arbeitsmedium erfolgt typischerweise nachträglich, also nach dem Ausbilden des Schichtsystems. Hierzu wird meist eine Befüllungsöffnung vorgesehen, durch die der Innenraum zunächst evakuiert und anschließend mit dem Arbeitsmedium befüllt wird, bevor er dauerhaft fluiddicht verschlossen wird.

Das Ausbilden der kanalförmigen Ausnehmung in dem Trägerelement erfolgt nach dem Stand der Technik typischerweise durch einen Fräsprozess. Da die Strukturen insbesondere bei einer mäanderartigen Ausgestaltung des Medienkanals relativ fein und komplex sind, ist dieser Herstellungsschritt jedoch vergleichsweise aufwändig. Es besteht somit ein Bedarf für ein alternatives Herstellungsverfahren für ein Wärmerohr und insbesondere ein pulsierendes Wärmerohr.

Aufgabe der Erfindung ist es daher, ein Verfahren zur Herstellung eines Wärmerohrs anzugeben, welches den genannten Nachteil überwindet. Insbesondere soll ein Herstellungsverfahren zur Verfügung gestellt werden, welches vergleichsweise einfach umzusetzen ist und trotzdem ein Wärmerohr mit einem geringen Wärmewiderstand ausbildet. Eine weitere Aufgabe ist es, ein entsprechendes Wärmerohr anzugeben sowie ein Elektronikmodul mit einem solchen Wärmerohr anzugeben.

Diese Aufgaben werden durch das in Anspruch 1 beschriebene Verfahren, das in Anspruch 14 beschriebene Wärmerohr und das in Anspruch 15 beschriebene Elektronikmodul gelöst.

Das erfindungsgemäße Verfahren dient zum Herstellen einer PHP, also eines Wärmerohrs mit einem geschlossenen Innenraum zum Transport eines fluiden Arbeitsmediums, insbesondere in einem selbständig pulsierenden Betrieb. Der Innenraum ist wenigstens durch ein flächiges Trägerelement und ein dem Trägerelement gegenüberliegendes flächiges Deckelement begrenzt, wobei der Innenraum zumindest teilweise durch eine kanalförmige Ausnehmung des Trägerelements und/oder des Deckelements definiert ist. Im Rahmen des erfindungsgemäßen Verfahrens wird diese kanalförmige Ausnehmung zumindest teilweise durch Anwendung eines Prägeschritts auf einen Rohling des Trägerelements und/oder einen Rohling des Deckelements ausgebildet. Im Anschluss an das Ausbilden der Ausnehmung wird das Trägerelement mit dem Deckelement direkt oder indirekt verbunden.

Der geschlossene Innenraum bildet also einen Medienkanal aus, welcher insbesondere eine insgesamt längliche Kanalform aufweisen kann. Das Wärmerohr arbeitet insbesondere selbständig pulsierend bzw. selbst-oszillierend, ist also allgemein bevorzugt eine PHP. Bei einem solchen selbst-oszillierenden bzw. selbständig pulsierenden Betrieb bilden sich in dem Medienkanal abwechselnde Segmente aus flüssigem und gasförmigem Arbeitsmedium aus, wie oben beschrieben. Die PHP kann insbesondere als flachplattige PHP (englisch: "flat plate pulsating heat pipe") ausgebildet sein, sie basiert dann also auf einem Schichtaufbau aus übereinanderliegenden flachen Schichten. Die Vorteile der Erfindung im Zusammenhang mit der vereinfachten Herstellung werden aber auch mit herkömmlichen (nicht-pulsierenden) Wärmerohren erreicht. So kann z.B. auch eine Kavität mit einer kapillaren Struktur für den Rücktransport des kondensierten Arbeitsmediums zumindest teilweise durch einen Prägeschritt ausgebildet werden.

Allgemein und unabhängig von dem genauen Funktionsprinzip und der genauen Form bilden jedenfalls das Trägerelement und das Deckelement zusammen einen Schichtstapel aus, wobei in einem Verbindungsbereich dieser beiden Elemente der Innenraum als innenliegender Medienkanal gebildet ist. Der Innenraum wird also weitgehend durch das Verbinden von Trägerelement und Deckelement gebildet. Geschlossen wird er aber typischerweise erst im Anschluss an diesen Schritt, insbesondere nach einem Evakuieren und einem Befüllen mit dem Arbeitsmedium über eine dafür vorgesehene separate Befüllungsöffnung. Diese Befüllungsöffnung kann danach dauerhaft verschlossen werden. Trägerelement und Deckelement können prinzipiell direkt oder indirekt miteinander verbunden werden. Bei einer indirekten Verbindung liegt also ein wenigstens Zwischenelement zwischen Trägerelement und Deckelement vor, welches ebenfalls zur Definition des Innenraums beiträgt.

Das Trägerelement ist zweckmäßig aus einem hochwärmeleitenden Material gebildet, beispielsweise aus einem metallischen Material. Das "hochwärmeleitende" Material ist insbesondere ein Material mit einer Wärmeleitfähigkeit von wenigstens 10 W/(m K) (z.B. gut wärmeleitende Kunststoffe) und bevorzugt sogar wenigstens 100 W/(m K) wie beispielsweise Kupfer oder Aluminium oder eine Legierung mit einem dieser Metalle. Auch das Deckelement ist vorteilhaft aus einem solchen oder ähnlichen Material gebildet. Das optional vorhandene Zwischenelement ist dagegen bevorzugt aus einem elektrisch isolierenden Material gebildet.

Insgesamt weist das Trägerelement und/oder das Deckelement wenigstens eine kanalförmige Ausnehmung und gegebenenfalls auch eine Mehrzahl von kanalförmigen Ausnehmungen auf. Durch die kanalförmige Ausnehmung (ggf. im Zusammenspiel mit entsprechenden Ausnehmungen der angrenzenden Elemente) ist ein insbesondere länglicher Medienkanal gebildet, in dem das Arbeitsmedium in dem beschriebenen selbst-oszillierenden Betrieb bewegt werden kann. Dieser selbst-oszillierende Transport kann sich insbesondere zwischen einem Verdampferbereich und einem Kondensatorbereich des Wärmerohrs erstrecken. Insgesamt kann sich eine Mehrzahl von Kanalsegmenten zwischen diesen beiden Bereichen erstrecken. Diese Mehrzahl von Kanalsegmenten kann insbesondere in einem Teilbereich des Wärmerohrs im Wesentlichen parallel zueinander verlaufen. Entsprechend kann die den Medienkanal (mit) definierende Ausnehmung des Trägerelements (und/oder des Deckelements) eine vergleichswese komplexe Form mit einer Mehrzahl von offenen Segmenten und einer Mehrzahl von dazwischen verlaufenden Stegen aufweisen.

Erfindungsgemäß wird das Ausbilden dieser Ausnehmung durch einen Prägeschritt ausgebildet. Dies erfolgt durch Eindrücken eines Prägewerkzeugs auf eine Hauptfläche eines Rohlings des Trägerelements und/oder durch Eindrücken eines Prägewerkzeugs auf eine Hauptfläche eines Rohling des Deckelements. Ein Prägen des Trägerelements ist dabei besonders bevorzugt, da in diesem meist mehr (vertikaler) Raum zum Ausbilden einer Kavität für das Wärmerohr zur Verfügung steht. Unter "Prägen" oder auch "Einprägen" wird allgemein nach DIN 8580 ein mechanischer Vorgang eines Fertigungsverfahrens aus der Gruppe des Eindrückens verstanden, das zum sogenannten Druckumformen zählt. Als Prägewerkzeug kann beispielsweise ein Prägestempel oder eine Prägerolle zum Einsatz kommen. Allgemein und unabhängig von der genauen Ausgestaltung bewirkt das Prägewerkzeug durch ein Andrücken auf eine (insbesondere vorher ebene) Werkstückoberfläche eine Verformung zu einem Relief. Im vorliegenden Zusammenhang definiert dieses Relief eine kanalförmige Ausnehmung für den Medienkanal des Wärmerohrs.

Ein wesentlicher Vorteil des erfindungsgemäßen Herstellungsverfahrens liegt darin, dass durch den Prägeschritt auf relativ einfache Weise eine vergleichsweise komplex geformte Ausnehmung im Trägerelement und/oder herstellbar ist. So kann insgesamt eine einfache und kostengünstige Herstellung eines Wärmerohrs mit einem niedrigen Wärmewiderstand ermöglicht werden. Mit einem solchen Wärmerohr ist eine effektive Entwärmung von elektronischen Bauelementen und anderen Wärmequellen möglich, wobei insbesondere ein vergleichsweise geringer Bauraum eingehalten werden kann.

Das erfindungsgemäße Wärmerohr weist einen geschlossenen Innenraum zum Transport eines fluiden Arbeitsmediums (insbesondere in einem selbständig pulsierenden Betrieb) auf, wobei der Innenraum wenigstens durch ein flächiges Trägerelement und ein dem Trägerelement gegenüberliegendes flächiges Deckelement begrenzt ist und wobei der Innenraum zumindest teilweise durch eine kanalförmige Ausnehmung des Trägerelements und/oder des Deckelements definiert ist. Das Wärmerohr ist mit einem erfindungsgemäßen Verfahren hergestellt. Insbesondere kann es sich um ein Wärmerohr zur Kühlung eines elektronischen Bauelements handeln. Die Ausbildung der Ausnehmung in dem Trägerelement und/oder dem Deckelement durch einen Prägeschritt ist an der Oberflächenstruktur im Bereich der Seitenwände des gebildeten Reliefs erkennbar.

Das erfindungsgemäße Elektronikmodul weist wenigstens ein elektronisches Bauelement und wenigstens ein erfindungsgemäßes Wärmerohr zur Entwärmung des elektronischen Bauelements auf. Hierzu ist das Bauelement mit dem Wärmerohr (direkt oder indirekt) thermisch gekoppelt. Die Vorteile des erfindungsgemäßen Wärmerohrs und des erfindungsgemäßen Elektronikmoduls ergeben sich analog zu den oben beschriebenen Vorteilen des erfindungsgemäßen Herstellungsverfahrens.

Vorteilhafte Ausgestaltungen und Weiterbildungen der Erfindung gehen aus den von Anspruch 1 abhängigen Ansprüchen sowie der folgenden Beschreibung hervor. Dabei können die beschriebenen Ausgestaltungen des Herstellungsverfahrens auch bei dem Wärmerohr bzw. dem Elektronikmodul realisiert werden, und umgekehrt.

So kann das Trägerelement allgemein vorteilhaft als Kühlkörper ausgebildet sein. Insbesondere kann das Trägerelement auf einer von dem Innenraum abgewandten Seite eine oberflächenvergrößernde Struktur aufweisen. Diese Struktur vergrößert die Oberfläche im Vergleich zu einer ebenen Oberfläche und bewirkt so eine Erhöhung der Wärmeabgabe des Kühlkörpers an die Umgebung, beispielsweise an eine Umgebungsluft oder ein anderes den Kühlkörper umgebendes, außenliegendes fluides Kühlmedium. Die oberflächenvergrößernde Struktur kann insbesondere eine Mehrzahl von Kühlrippen aufweisen bzw. aus solchen Kühlrippen bestehen. Alternativ oder zusätzlich können auch andere oberflächenvergrößernde Strukturen wie Kühlsterne, Kühlfahnen, Kühlsäulen und/oder sogenannte Pin Fins zum Einsatz kommen. Die oberflächenvergrößernde Struktur kann prinzipiell vor oder nach dem erfindungsgemäßen Prägeschritt hergestellt werden, bevorzugt wird sie jedoch vor dem Prägeschritt hergestellt. Der beim Prägeschritt eingesetzte Druck bzw. die Anpresskraft werden dann vorteilhaft so dimensioniert, dass die oberflächenvergrößernde Struktur nicht geschädigt wird. Die Struktur kann auch durch Einbettung eine Stützform vor einer Schädigung geschützt werden. Die Herstellung der oberflächenvergrößernden Struktur kann beispielsweise durch Fräsen, Strangpressen und/oder durch ein additives Fertigungsverfahren erfolgen. Das Trägerelement kann insgesamt einstückig mit der oberflächenvergrößernden Struktur des Kühlkörpers ausgebildet sein. Alternativ ist jedoch auch eine mehrstückige Ausführung möglich, bei der ein vorgefertigter Kühlkörper mit einer oberflächenvergrößernden Struktur nachträglich mit einem (insbesondere plattenförmigen) Trägerelement zusammengesetzt wird. Auch dieses Zusammensetzen kann prinzipiell vor oder nach dem erfindungsgemäßen Prägeschritt erfolgen, bevorzugt ist aber in diesem Fall ein nachträgliches Zusammensetzen.

Gemäß einer allgemein vorteilhaften Ausführungsform kann das Wärmerohr zwischen dem Trägerelement und dem Deckelement ein oder mehrere flächige Zwischenelemente aufweisen. Ein solches flächiges Zwischenelement kann insbesondere ein flächiges Isolationselement sein, welches aus einem elektrisch isolierenden Material gebildet ist. Beispielsweise kann ein solches Isolationselement aus einem Kunststoff oder einem keramischen Material wie Aluminiumoxid oder Aluminiumnitrid gebildet sein. Es kann ebenfalls eine kanalförmige Ausnehmung aufweisen, so dass sich der Medienkanal des Wärmerohrs zumindest teilweise in die Schichtebene des Isolationselements erstreckt. Ein Vorteil eines solchen Isolationselements besteht in der elektrischen Isolation zwischen dem Material des Deckelements und dem Material des Trägerelements. Trägerelement und Deckelement können insbesondere aus elektrisch leitendem Material gebildet sein. Vor allem wenn das Deckelement mit einem elektronischen Bauteil verbunden ist, kann eine elektrische Isolation zwischen diesen Elementen sinnvoll sein, um eine unerwünschte elektrische Kontaktierung zwischen dem Bauelement und dem Kühlkörper zu vermeiden. Allgemein und unabhängig von der Materialwahl kann ein solches Zwischenelement z.B. als vorgefertigtes flächiges Element zwischen Trägerelement und Deckelement nach Art eines Inlays eingelegt werden, bevor die Verbindung des Schichtsystems ausgebildet wird. Das vorgefertigte Zwischenelement kann beispielsweise wenigstens eine ausgestanzte Ausnehmung aufweisen. Es kann auch aus mehreren Teilelementen innerhalb einer Schichtebene zusammengesetzt sein. Alternativ zu einer solchen vorgefertigten Ausführung kann das Zwischenelement auch in-situ auf dem Trägerelement gebildet werden, beispielsweise durch ein additives Fertigungsverfahren. Insbesondere bei einer Ausführung aus einem Kunststoff kann das Material des Zwischenelements additiv auf den gewünschten Bereichen des Trägerelements aufgebracht werden, und der Schichtstapel aus Trägerelement, Zwischenelement und Deckelement kann anschließend durch ein temporäres Aufschmelzen des Kunststoffs miteinander dauerhaft verbunden werden.

Gemäß einer allgemein vorteilhaften Ausführungsform kann bei dem Prägeschritt wenigstens ein Prägestempel und/oder eine Prägerolle als Prägewerkzeug verwendet werden. Ein Prägestempel ist ein Prägewerkzeug, welches in einer linearen Translationsbewegung auf eine Prägefläche des zu verformenden Werkstücks (hier des Trägerelements) zu bewegt wird und im Wesentlichen orthogonal zur Oberfläche angedrückt wird. Eine Prägerolle wird dagegen lateral (parallel zur Oberfläche) an der Oberfläche entlanggerollt und gleichzeitig ebenfalls orthogonal zur Oberfläche angedrückt.

Weiterhin vorteilhaft ist es, wenn innerhalb des Prägeschritts das Prägewerkzeug mit dem Trägerelement auf einer Kontaktfläche in Berührung tritt, welche kleiner ist als die dem Prägewerkzeug zugewandte Hauptfläche des Trägerelements. Analoges gilt für ein Prägen des Deckelements. Besonders bevorzugt kann der Verkleinerungsfaktor in einem Bereich zwischen 1,5 und zehn liegen. Eine entsprechend verkleinerte Kontaktfläche ist vorteilhaft, um bei dem für die Herstellung der Ausnehmung erforderlichen Anpressdruck die einwirkende Kraft insgesamt gering zu halten und dadurch eine Schädigung der übrigen Bereiche des Trägerelements bzw. Deckelements zu vermeiden. Dies ist insbesondere dann relevant, wenn das Trägerelement auf einer dem Innenraum abgewandten Seite eine oberflächenvergrößernde Struktur aufweist, die durch zu hohe Krafteinwirkung geschädigt werden könnte. Bei einer derartig verkleinerten Prägefläche kann das auszubildende Relief zur sequenziellen Ausführung mehrerer Teil-Prägeschritte ausgebildet werden. Dabei können je nach der Form des auszubildenden Reliefs gleiche und/oder unterschiedliche Prägewerkzeuge zum Einsatz kommen. Beispielsweise kann sich in einem mittleren Bereich des Reliefs ein Prägemuster regelmäßig wiederholen, so dass mit demselben Prägestempel mehrere Abschnitte eines größeren Reliefs geprägt werden können.

Gemäß einer weiteren Ausgestaltung der Erfindung kommt zusätzlich zu dem (wenigstens einen) Prägeschritt ein weiterer Verfahrensschritt mit einem von dem Prägeverfahren unterschiedlichen Verformungsverfahren und/oder abtragenden (subtraktiven) Verfahren für die Ausbildung der kanalförmigen Ausnehmung des Trägerelements und/oder Deckelements zum Einsatz. Beispielsweise können ein oder mehrere Teilbereiche der kanalförmigen Ausnehmung durch ein Fräsverfahren gebildet sein. Dieser weitere Verfahrensschritt kann insbesondere im Anschluss an den Prägeschritt durchgeführt werden. Eine solche Verfahrenskombination kann vorteilhaft sein, wenn die kanalförmige Ausnehmung Teilbereiche mit unterschiedlicher geometrischer Komplexität aufweist. So können z.B. die gebogenen Endbereiche (Umkehrbereiche) einer mäanderförmigen Kanalstruktur vorteilhaft durch einen Prägeschritt gebildet sein, da sie relativ komplex sind und mit einem Fräsverfahren schwierig herstellbar sind. Dagegen können die dazwischenliegenden geraden Abschnitte einer mäanderförmigen Kanalstruktur relativ leicht mit einem Fräsverfahren hergestellt werden. Durch eine solche Aufteilung in unterschiedliche Bearbeitungsprozesse kann eine mechanische Schädigung des Trägerelements bzw. Deckelements durch den Prägedruck wirksam vermieden oder zumindest reduziert werden. Alternativ kann die kanalförmige Ausnehmung aber auch vollständig durch einen oder mehrere Prägeschritte realisiert werden.

Allgemein können bei der Ausbildung der kanalförmigen Ausnehmung mehrere sequenzielle Prägeschritte zum Einsatz kommen. Dabei kann prinzipiell dasselbe Prägewerkzeug mehrfach nacheinander zum Einsatz kommen, oder es können (besonders bevorzugt) mehrere unterschiedlich geformte Prägewerkzeuge nacheinander zum Einsatz kommen. Auf diese Weise kann der Anpressdruck bzw. die Anpresskraft bei einem einzelnen Prägeschritt vorteilhaft niedrig gehalten werden. Außerdem werden durch ein solches Mehrfachprägen auch komplexere Strukturen des gebildeten Reliefs möglich. Die dadurch gebildete Ausnehmung kann insbesondere gebogene Seitenwände, gestufte Seitenwände und/oder im Vergleich zur Flächennormalen des flächigen Trägerelements schräg verlaufende Seitenwände aufweisen.

Allgemein vorteilhaft kann die kanalförmige Ausnehmung zumindest in Teilbereichen einen trapezförmigen Kanalquerschnitt aufweisen. Die Seitenwände der kanalförmigen Ausnehmung können also relativ zur Flächennormalen des flächigen Trägerelements (bzw. eines flächigen Deckelements) angeschrägt sein. Eine solche Trapezform kann insbesondere durch ein entsprechendes trapezförmiges Relief des Prägewerkzeugs erreicht werden, wenn sich der Querschnitt der kanalförmigen Ausnehmung zur Außenseite des Trägerelements hin vergrößert. Allgemein ist eine solche Formgebung vorteilhaft, um eine Reibung des Prägewerkzeugs an der ausgebildeten Kanalwandung während des Prägeschritts gering zu halten. Somit können Materialabrisse oder sonstige Schädigungen des Trägerelements und/oder des Prägewerkzeugs beim Prägeschritt vermieden werden.

Gemäß einer weiteren Ausgestaltung der Erfindung weist die kanalförmige Ausnehmung zumindest in Teilbereichen einen abgerundeten Boden auf. Unter dem "Boden" wird hierbei die innenliegende Begrenzung der Ausnehmung hin zum Hauptvolumen des Trägerelements bzw. Deckelements verstanden, also die untere Begrenzung in vertikaler Richtung. Allgemein soll "vertikal" im vorliegenden Zusammenhang die Richtung orthogonal zu den Hauptflächen des flächigen Trägerelements bzw. Deckelements bezeichnen, und "lateral" soll die Richtungen parallel zu diesen Hauptflächen bezeichnen. Ein abgerundeter Boden kann vorteilhaft sein, um Strömungsabrisse zu vermeiden und auch bei größeren Kanalquerschnitten eine Segmentierung in die miteinander wechselnden zusammenhängenden Segmente des Arbeitsmediums aus Dampf und Flüssigkeit sicherzustellen, die für den Betrieb eines pulsierenden Wärmerohrs nötig sind. Entsprechend können bei einer solchen Formgebung größere Kanalquerschnitte realisiert werden.

Allgemein vorteilhaft kann der geschlossene Innenraum (also der Medienkanal) einen ringförmig geschlossenen Kanal ausbilden, in dem das Arbeitsmedium zirkulieren kann. Die Zirkulationsrichtung kann dabei entweder im Verlauf des Betriebs des Wärmerohrs im Wesentlichen gleichbleibend sein, was typischerweise als pulsierender Betrieb bezeichnet wird, oder sie kann im Verlauf des Betriebs hin und her wechseln, was typischerweise als oszillierender Betrieb bezeichnet wird. Da diese beiden Betriebsformen miteinander wechseln können, wird in der Literatur zwischen den Begriffen eines oszillierenden Wärmerohrs und eines pulsierenden Wärmerohrs nicht streng unterschieden. Auch im Rahmen der vorliegenden Erfindung sollen generell beide Betriebsarten umfasst sein.

Weiterhin vorteilhaft kann der geschlossene Innenraum eine Mehrzahl von mäanderförmigen Windungen aufweisen und durch eine Mehrzahl von zwischen den Windungen liegenden Stegen begrenzt sein. Eine solche Ausführung kann vorteilhaft sein, um zwischen einem Verdampferbereich und einem Kondensatorbereich des Wärmerohrs insgesamt ein Bündel von im Wesentlichen parallel zueinander verlaufenden Kanalsegmenten auszubilden. Diese einzelnen Kanalsegmente können dabei Teil eines übergeordneten ringförmig geschlossenen Kanals sein, wie oben beschrieben. Ein solches Kanalbündel bewirkt, dass sich insgesamt eine Vielzahl von Kanalsegmenten zwischen Verdampferbereich und Kondensatorbereich erstreckt, was zu einem effektiven Wärmetransport zwischen diesen Teilbereichen führt.

Allgemein kann die Querschnittsfläche eines einzelnen Kanalsegments in einem Bereich zwischen 0,25 mm² und 4 mm² liegen. Die laterale Kanalbreite kann vorteilhaft zwischen 0,5 mm und 2 mm liegen. Die laterale Stegbreite eines zwischen den Kanalsegmenten liegenden Stegs kann ebenfalls vorteilhaft zwischen 0,5 mm und 2 mm liegen. Bei den genannten Dimensionierungen des Medienkanals kann mit den typischen Arbeitsmedien von Wärmerohren besonders vorteilhaft ein stabiler selbständig oszillierender Betrieb erreicht werden. Vorteilhafte Arbeitsmedien sind beispielsweise Wasser, Ethanol, n-Pentan, Perfluor-N-alkyl-morpholin sowie die unter den Namen Novec 649, Novec 7000 und Novec 7100 vertriebenen Fluide.

Gemäß einer vorteilhaften Weiterbildung der mäanderförmigen Ausgestaltung des Medienkanals kann zumindest ein Teil der vorhandenen Stege gestaucht werden, insbesondere in einer Richtung orthogonal zu einer Hauptfläche des Trägerelements bzw. des Deckelements. Eine solche vertikale Stauchung kann vorteilhaft sein, um die Querschnittsgeometrie des von dem jeweiligen Steg begrenzten Kanalsegments nach außen hin abzurunden. Ähnlich wie bei der Ausführungsform mit einem abgerundeten Boden kann dies vorteilhaft sein, um auch bei einem vergleichsweise großen Kanalquerschnitt einen stabilen selbst-oszillierenden Betrieb zu ermöglichen. Das Stauchen der Stege kann entweder im Anschluss an den wenigstens einen Prägeschritt oder prinzipiell auch während eines solchen Prägeschritts erfolgen, insbesondere wenn mehrere sequenzielle Prägeschritte ausgeführt werden.

Gemäß einer weiteren vorteilhaften Weiterbildung der mäanderförmigen Ausgestaltung des Medienkanals kann zumindest ein Teil der Stege auf einer dem Deckelement zugewandten Seite mit einer Einprägung versehen werden, insbesondere mit einer Einkerbung. Eine solche vertikale Einprägung auf der Außenseite der Stege kann vorteilhaft sein, um eine größere Verbindungsfläche für die nachfolgend herzustellende Verbindung zwischen Trägerelement, Deckelement, und/oder optionalem Zwischenelement zu schaffen. Beispielsweise kann eine solche Verbindung durch eine Verlötung oder Verklebung geschaffen werden, wobei sich die Ausbildung einer Einkerbung günstig auswirkt. Die vertikale Einprägung kann sich vorteilhaft länglich in Längsrichtung des jeweiligen Stegs erstrecken und sie kann insbesondere auf einem überwiegenden Teil seiner Länge vorhanden sein. Alternativ zu einer solchen länglichen Einprägung kann jedoch auch eine Vielzahl von über die Länge des jeweiligen Stegs verteilten einzelnen Einprägungen vorhanden sein, insbesondere eine Vielzahl von in Längsrichtung aneinandergereihten eingeprägten Dellen. Die Einkerbung kann insbesondere jeweils mittig im Steg, also mittig zwischen dem von dem jeweiligen Steg getrennten Kanälen angeordnet sein.

Gemäß einer weiteren vorteilhaften Weiterbildung der mäanderförmigen Ausgestaltung des Medienkanals kann zumindest ein Teil der Stege auf einer dem Deckelement zugewandten Seite gestuft geformt sein. Es können sich also ein oder mehrere Stufen im jeweiligen Steg befinden, insbesondere im Randbereich des Stegs. Dann ist auch die den Medienkanal begrenzende Seitenwand entsprechend gestuft. Eine solche gestufte Ausführung im Randbereich kann sich ebenfalls vorteilhaft auf eine nachträglich geschaffene Verbindung zwischen den Stegen und einem weiteren Element auswirken. Zum einen wird auch hierdurch die Verbindungsfläche vergrößert, ähnlich wie bei der Einkerbung. Zum anderen wird generell auch schon dadurch eine verbesserte mechanische Belastbarkeit der gebildeten Verbindung erreicht, dass nicht nur eine stirnseitige (vertikale) Verbindung auf der Oberseite der Stege, sondern auch eine seitliche (laterale) Verbindung zwischen den Stegen und einem passend dazu gestuften Zwischenelement bzw. Deckelement ausgebildet werden kann. Entsprechend ist die so ausgebildete Verbindung nicht nur gegenüber vertikalen Zugbelastungen, sondern auch gegenüber lateralen Scherbelastungen stabilisiert. Somit wird insgesamt eine höhere Druckfestigkeit des geschlossenen Innenraums des Wärmerohrs erreicht.

Gemäß einer besonders vorteilhaften Ausführungsform des Elektronikmoduls kann das wenigstens eine elektronische Bauelement ein Bauelement der Leistungselektronik sein, beispielsweise ein MOSFET oder ein IGBT. Alternativ kann es sich aber auch um eine Leuchtdiode, eine Solarzelle und/oder eine andere Art von Halbleiterbauelement handeln. Insbesondere kann auch eine Mehrzahl von solchen elektronischen Bauelementen in dem Elektronikmodul vorhanden sein und mittels des Wärmerohrs entwärmt werden.

Innerhalb des Elektronikmoduls ist das wenigstens eine Bauelement thermisch so mit dem wenigstens einen Wärmerohr gekoppelt, dass es über dieses Wärmerohr entwärmt werden kann. Insbesondere ist das elektronische Bauelement mit einem Verdampferbereich des Wärmerohrs gekoppelt, so dass beim Betrieb des Bauelements dissipierte Abwärme über das Wärmerohr in Richtung seines Kondensorbereichs transportiert werden kann. Somit kann eine effektive Wärmespreizung der beim Betrieb des Elektronikmoduls freigesetzten Wärme erreicht werden. Allgemein kann das Wärmerohr so ausgestaltet sein, dass damit eine laterale Wärmespreizung parallel zu einer Hauptebene eines Halbleiterchips des elektronischen Bauelements erzielt werden kann. Alternativ oder zusätzlich kann jedoch auch ein vertikaler Wärmetransport erreicht werden, so dass insbesondere Abwärme des Halbleiterchips von dem Halbleiterchip in vertikaler Richtung (also orthogonal zur Chipebene) in einen hochwärmeleitenden Kühlkörper eingebracht wird, von welchem aus die Wärme an die Umgebung abgegeben werden kann.

Für die thermische Ankopplung an das Wärmerohr kann das elektronische Bauelement direkt oder indirekt mit dem Arbeitsmedium in Kontakt sein. Gemäß einer ersten Variante kann das elektronische Bauelement mit dem Deckelement verbunden sein und von diesem getragen werden. Bei dieser Variante wird der Wärmeeintrag in das Arbeitsmedium also durch das Deckelement vermittelt. Hierzu kann das Deckelement aus einem hochwärmeleitenden Material und plattenförmig ausgestaltet sein, um einen möglichst kurzen Wärmetransportweg zu erreichen. Insbesondere beträgt der Abstand zwischen einem Halbleitermaterial des Bauelements und dem Arbeitsmedium vorteilhaft höchstens 3 mm, bevorzugt höchstens 0,5 mm oder sogar deutlich weniger. Gemäß einer zweiten Variante kann ein Halbleitermaterial des elektronischen Bauelements auch in direktem Kontakt mit dem Innenraum stehen, so dass es zumindest in einem Teilbereich von dem Arbeitsmedium angeströmt werden kann. Hierzu kann ein Halbleiterchip des Bauelements im Bereich von ein oder mehreren Ausnehmungen des Deckelements auf dem Deckelement montiert sein, so dass das Arbeitsmedium durch die jeweilige Ausnehmung den Halbleiterchip anströmen kann. Alternativ kann der Halbleiterchip auch innerhalb des Medienkanals des Wärmerohrs angeordnet sein. Beide Varianten können insbesondere so umgesetzt sein, wie dies in der Europäischen Patentanmeldung EP 3823018 A1 beschrieben ist.

Allgemein bezieht sich die vorliegende Erfindung auch auf ein Herstellungsverfahren für ein erfindungsgemäßes Elektronikmodul. Zusätzlich zu dem Verfahren zur Herstellung des Wärmerohrs umfasst dieses weitere Herstellungsverfahren noch eine Verbindung des wenigstens einen so hergestellten Wärmerohrs mit wenigstens einem elektronischen Bauelement, wobei eine thermische Kopplung des Bauelements mit dem Wärmerohr für die beschriebene Entwärmung erreicht wird.

Nachfolgend wird die Erfindung anhand einiger bevorzugter Ausführungsbeispiele unter Bezugnahme auf die angehängten Zeichnungen beschrieben, in denen:
Figur 1 ein erstes Ausführungsbeispiel eines Wärmerohrs in einer ersten Schnittdarstellung zeigt,
Figur 2 das Wärmerohr der Figur 1 in einer zweiten Schnittdarstellung zeigt,
Figur 3 eine schematische perspektivische Ansicht eines Trägerelements kurz nach einem Prägeschritt zeigt,
Figuren 4 bis 7 mehrere Trägerelemente mit unterschiedlichen Geometrien der kanalförmigen Ausnehmungen zeigen,
Figur 8 ein Trägerelement bei der Verbindung mit weiteren Elementen zeigt und
Figur 9 eine schematische Abfolge von ausgewählten Schritten eines beispielhaften Herstellungsverfahrens zeigt.

In den Figuren sind gleiche oder funktionsgleiche Elemente mit gleichen Bezugszeichen versehen.

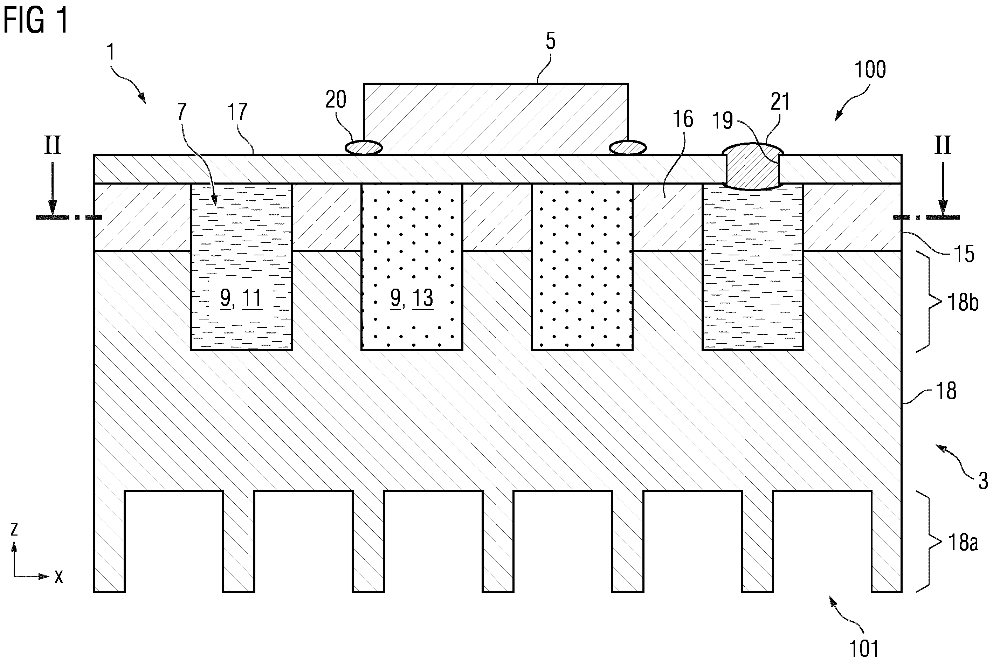

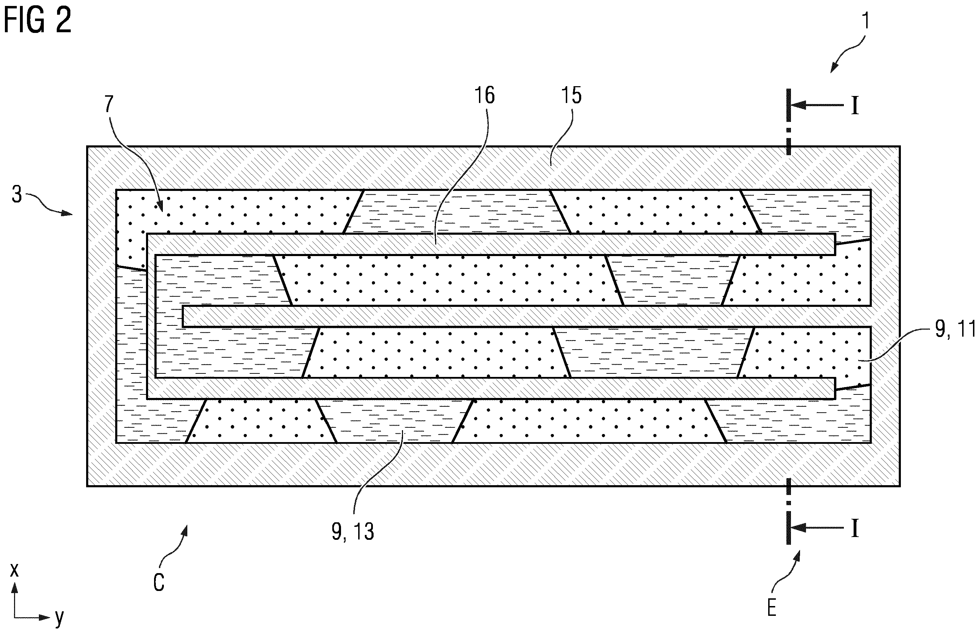

Die Figuren 1 und 2 zeigen ein erstes Ausführungsbeispiel eines erfindungsgemäßen Elektronikmoduls 1 in zwei Schnittdarstellungen mit zueinander orthogonalen Schnittebenen. Das Elektronikmodul 1 umfasst ein Wärmerohr 3, das zum Betrieb als pulsierende Heatpipe ausgelegt ist und ein elektronisches Bauelement 5, insbesondere einen Halbleiterchip.

Das Wärmerohr 3 ist eine flachplattige PHP und ist aus einem sandwichartigen Schichtstapel aus mehreren flachen Elementen 15, 16, 17 und 18 zusammengesetzt. Die Ausdehnung in der vertikalen Richtung z senkrecht zur Schichtebene kann im Vergleich zu den anderen beiden lateralen Richtungen x und y noch wesentlich geringer ausfallen als in Figur 1 angedeutet ist.

Das Wärmerohr 3 weist einen geschlossenen Innenraum 7 auf, der einen Medienkanal für ein Arbeitsmedium 9 des Wärmerohrs 3 bildet. Dieser Innenraum 7 ist als ein mäanderartig verlaufender und insgesamt ringförmig geschlossener Kanal ausgebildet. Das Arbeitsmedium 9 bildet entlang dieses Medienkanals 7 abwechselnd Dampfsegmente 11, in denen das Arbeitsmedium 9 in einer gasförmigen Phase vorliegt, und Flüssigsegmente 13, in denen das Arbeitsmedium 9 in einer flüssigen Phase vorliegt. Die Dampfsegmente 11 und Flüssigsegmente 13 werden in dem Medienkanal 7 durch Temperaturgradienten zu pulsierenden bzw. oszillierenden Bewegungen angeregt. Das Arbeitsmedium 9 ist beispielsweise Perfluor-N-alkyl-morpholin.

Der Medienkanal 7 wird von einem Trägerelement 18 und einem Deckelement 17 und zwei dazwischenliegenden Zwischenelementen 15,16 begrenzt. Dabei sind die Zwischenelemente allgemein optional, und es kann alternativ auch das Trägerelement 18 unmittelbar mit dem Deckelement 17 verbunden sein. Der Medienkanal 7 wird zumindest teilweise durch wenigstens eine kanalförmige Ausnehmung des Trägerelements 18 gebildet, welche sich in diesem Beispiel in vertikaler Richtung (z) in die Ebene der Zwischenelemente 15, 16 fortsetzt. Alternativ zu der hier gezeigten Ausführung kann auch nur ein insgesamt zusammenhängendes Zwischenelement vorliegen, insbesondere wenn die Ausnehmung des Zwischenelements nicht in z-Richtung durchgängig ist. Das jeweilige Zwischenelement 15, 16 kann aus einem elektrisch isolierenden Material gebildet sein und somit ein Isolationselement ausbilden. Insbesondere kann es aus einem Kunststoff gebildet sein. Dagegen können Trägerelement 18 und Deckelement 17 jeweils aus einem metallischen Material gebildet sein, wobei die Isolationselemente 15, 16 diese metallischen Elemente elektrisch gegeneinander isolieren.

Der durch die Ausnehmungen gebildete Medienkanal 7 weist laterale und vertikale Ausdehnungen im Bereich von 0,5 mm bis 2 mm auf. Die Wände zwischen benachbarten, parallel zueinander verlaufenden Kanalabschnitten weisen beispielsweise eine Dicke (Stegbreite) im Bereich von 0,5 mm bis 2 mm innerhalb eines Mäanderfeldes (s.o.) auf. Ferner bilden Randbereiche des Trägerelements 18 sowie des Zwischenelements 15 in der x,y-Ebene zusammen einen äußeren Rahmen um die mäanderartige Kanalstruktur. Es sind hier beispielhaft nur zwei mäanderartige Windungen mit insgesamt vier parallel zueinander verlaufenden Kanalabschnitten gezeigt. In Wirklichkeit kann die Anzahl dieser Windungen und entsprechend auch die Anzahl der parallelen Kanalabschnitte wesentlich höher liegen.

Das Deckelement 17 verschließt den Medienkanal 7 deckelartig auf einer Oberseite 100 des Wärmerohrs 3. Das Deckelement 17 ist beispielsweise aus Kupfer oder Aluminium gefertigt. Das Trägerelement 18 verschließt den Medienkanal 7 auf einer dem Deckelement 17 gegenüberliegenden Unterseite 101 des Wärmerohrs 3. Auch das Trägerelement 18 ist beispielsweise aus Kupfer oder Aluminium gefertigt. Beim Beispiel der Figur 1 stellt das Trägerelement 18 einen Kühlkörper für das Elektronikmodul 1 dar und weist entsprechend auf einer von dem Halbleiterchip 5 abgewandten Unterseite 101 eine Mehrzahl von Kühlrippen 18a auf. Dies ist jedoch nicht unbedingt notwendig. Für eine laterale Wärmespreizung kann das Trägerelement 18 auch als im Wesentlichen flache Platte ohne solche oberflächenvergrößernden Strukturen ausgestaltet sein.

Das elektronische Bauelement 5 ist beispielsweise ein leistungselektronisches Bauelement, z.B. ein MOSFET oder ein IGBT. Das elektronische Bauelement 5 ist in einem Verdampferbereich E des Wärmerohrs 3 an dem Deckelement 17 angeordnet und mit dem Deckelement 17 elektrisch leitend und durch eine Lotverbindung 20 stoffschlüssig verbunden. Das Deckelement 17 steht unterhalb des elektronischen Bauelements 5 in direktem Kontakt mit dem Arbeitsmedium 9 und ermöglicht dadurch eine gute Wärmeleitung von dem elektronischen Bauelement 5 zu dem Arbeitsmedium 9. Das Arbeitsmedium 9 nimmt von dem elektronischen Bauelement 5 beim Betrieb freigesetzte Wärme auf, insbesondere in Form von latenter Wärme durch Verdampfen flüssigen Arbeitsmediums 9, und leitet die Wärme dem Kondensatorbereich C des Wärmerohrs 3 zu, wo das Arbeitsmedium 9 Wärme, insbesondere in Form von latenter Wärme durch Kondensieren gasförmigen Arbeitsmediums 9, abgibt. Somit wird insgesamt ein Wärmetransport vom Verdampferbereich E zum Kondensatorbereich C erreicht, also eine laterale Wärmespreizung. Zusätzlich findet in vertikaler Richtung (z) ein Wärmetransport von der Oberseite 100 des Elektronikmoduls 1, auf der sich das Bauelement 5 befindet, hin zur Unterseite 101 statt, auf welcher sich die Kühlrippen 18a des Trägerelements 18 befinden. So kann insgesamt eine effektive Entwärmung des Bauelements 5 erreicht werden.

Das Deckelement 17 weist eine Befüllungsöffnung 19 auf, durch die der Medienkanal 7 mit dem Arbeitsmedium 9 befüllt wird. Vor dem Befüllen wird der Medienkanal 7 zweckmäßig evakuiert, um Verunreinigungen mit anderen Stoffen vermeiden. Die Befüllungsöffnung 19 wird nach dem Befüllen des Medienkanals 7 mit einem Füllmaterial 21 verschlossen, beispielsweise durch Löten oder Laserschweißen.

Der Schichtaufbau und die Kanalgeometrie des Wärmerohrs 3 der Figuren 1 und 2 ist jedoch nur beispielhaft zu verstehen, und auch die Ankopplung des elektronischen Bauelements 5 kann anders realisiert sein, beispielsweise durch eine direkte Anspülung mit dem Arbeitsmedium 9. Andere Arten der Ausgestaltung können beispielsweise aus der oben zitierten Dissertation von F. Schwarz und aus der Patentanmeldung EP 3823018 A1 abgeleitet werden.

Wesentlich im Zusammenhang mit der vorliegenden Erfindung ist, dass das Relief 18b des Trägerelements 18, durch welches die innenliegende Kanalstruktur des Medienkanals (zumindest teilweise) definiert wird, durch einen Prägeschritt ausgebildet wird. Dieser Prägeschritt muss dabei nicht zwangsläufig das gesamte Relief 18b ausbilden, sondern wenigstens einen Teil davon. Mit anderen Worten können auch andere Prozessschritte wie z.B. ein Frässchritt zum Einsatz kommen, um das durch den Prägeschritt ausgebildete Relief 18b zu vervollständigen.

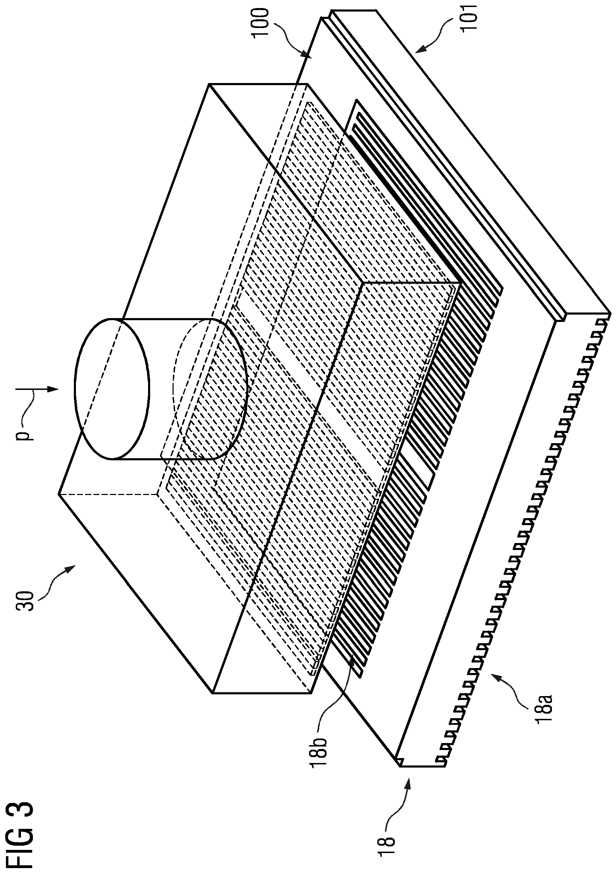

In Figur 3 ist eine schematische perspektivische Darstellung eines Trägerelements 18 gezeigt, dessen oberseitiges Relief 18b durch einen Prägeschritt erzeugt wurde. Oberhalb von dem Trägerelement 18 ist ein Prägewerkzeug 30 gezeigt, welches hier als Prägestempel ausgestaltet ist. Dieser Prägestempel wurde kurz vor dem gezeigten Prozessstadium mit einem Anpressdruck p in z-Richtung gegen die Oberseite 100 des Trägerelements 18 gedrückt, wodurch das mäanderförmige Relief 18b eingeprägt wurde. Hierdurch wurde eine komplexe kanalförmige Ausnehmung gebildet, die (ggf. im Zusammenspiel mit einer entsprechenden Ausnehmung eines optionalen Zwischenelements) den Medienkanal 7 definiert. Insgesamt kann mit dem Trägerelement 18 der Figur 3 ein ähnliches Wärmerohr gebildet werden, wie das Wärmerohr 3 der Figuren 1 und 2, wobei hier die laterale Geometrie des Medienkanals 7 wesentlich komplexer ausgestaltet ist und eine höhere Anzahl von mäanderförmigen Windungen aufweist.

Alternativ zu dem in Figur 3 dargestellten Prägeverfahren mit einem Prägestempel 30 kann auch eine Prägerolle verwendet werden. Auch kann es vorteilhaft sein, das auszubildende Relief 18b in mehreren Schritten mit mehreren kleineren Prägewerkzeugen bzw. unter mehrfacher Anwendung eines kleineren Prägewerkzeugs auszubilden. Wenn die Kontaktfläche zwischen Prägewerkzeug z.B. um einen Faktor zwei bis zehn kleiner ist als die Fläche des auszubildenden Reliefs 18b, dann kann die in z-Richtung wirkende Kraft vorteilhaft geringgehalten werden, wobei trotzdem lokal ein ausreichend hoher Anpressdruck p erreicht wird. Dies kann dazu beitragen, eine bereits auf der Unterseite des Reliefs ausgebildete Kühlstruktur 18a vor einer Schädigung zu schützen. Insgesamt sind Prägeverfahren für metallische Werkstoffe aus dem Stand der Technik hinreichend bekannt, und es sind zahlreiche Verfahrensvariationen möglich. Die Tiefe des eingeprägten Reliefs (also die ausgebildete Kanaltiefe in z-Richtung) kann beispielsweise zwischen 1 mm und 2 mm betragen. Der Prägeschritt kann beispielsweise bei einer Prozesstemperatur im Bereich der Raumtemperatur erfolgen, wobei der Anpressdruck jeweils so gewählt wird, dass eine ausreichende Relieftiefe im Material des Trägerelements 18 erreicht werden kann.

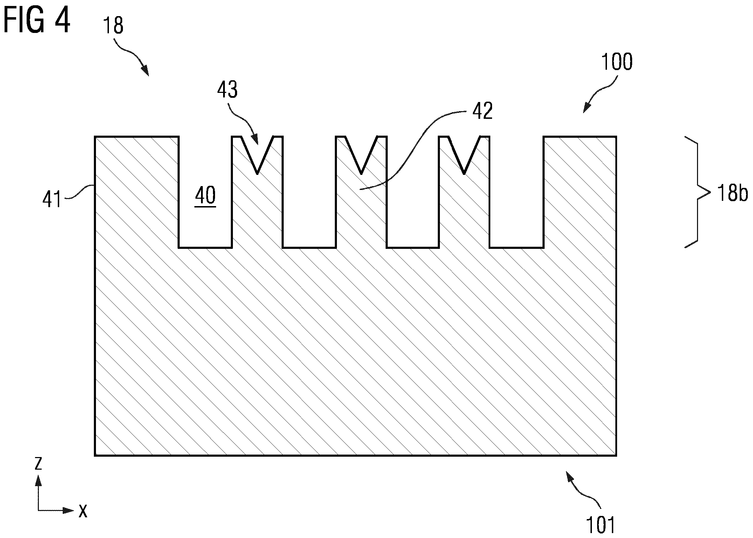

In den Figuren 4 bis 8 sind mehrere Trägerelemente 18 im schematischer Schnittdarstellung gezeigt, wobei sich die Geometrien der jeweils ausgebildeten Reliefs 18b voneinander unterscheiden. Gezeigt ist hier jeweils nur das oberseitige, (mit) durch einen Prägeschritt ausgebildete Relief 18b, wobei optional auf der Unterseite noch zusätzliche Kühlstrukturen 18a vorliegen können, ähnlich wie in den Figuren 1 und 3 gezeigt. Beim Ausführungsbeispiel der Figur 4 weist die durch das Prägerelief 18b gebildete kanalförmige Ausnehmung 40 vier parallel zueinander verlaufende Kanalsegmente auf, welche hier jeweils im Querschnitt zu sehen sind. Lateral dazwischen liegen insgesamt drei Stege 42, und die außenliegenden Kanalsegmente werden jeweils von einem breiteren, massiven Randbereich 41 des Trägerelements 18 flankiert.

Beim Beispiel der Figur 4 weisen die einzelnen Stege 42 jeweils eine mittige Einprägung 43, die hier als V-förmige Einkerbung realisiert ist. Diese Einkerbung 43 kann beispielsweise im selben Prägeschritt ausgebildet werden wie die übrigen Teile des Reliefs, also insbesondere durch Verwendung eines entsprechend geformten Prägewerkzeugs 30. Alternativ kann die Einprägung 43 aber auch durch einen nachfolgenden Prägeschritt oder auch durch eine andere Art von Prozessschritt erzeugt werden. Durch eine solche Einkerbung 43 kann eine verbesserte stoffschlüssige Verbindung mit einem auf das Trägerelement aufgebrachten Zwischenelement 15 bzw. 16 oder mit einem direkt darauf aufgebrachten Deckelement 17 erreicht werden.

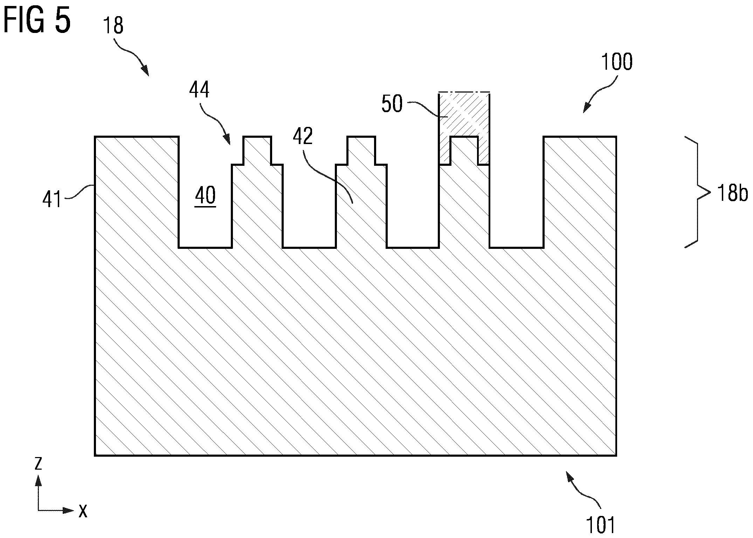

Beim Beispiel der Figur 5 weisen die Stege 42 in ihrem Randbereich jeweils eine zusätzliche Stufe 44 auf. Auch eine solche Stufe kann insbesondere im selben Prägeschritt wie das übrige Relief 18b oder auch in einem gesonderten Prägeschritt erzeugt werden. Auch eine solche Stufe ermöglicht eine verbesserte stoffschlüssige Verbindung mit einem nachfolgenden Zwischenelement oder Deckelement. Im rechten Teil der Figur 4 ist beispielhaft ein einzelner Steg 50 eines mit dem Trägerelement 18 zu verbindenden Zwischenelements zeigt. Das Zwischenelement kann eine flächige Kunststoffplatte sein, in welchem sich die kanalförmige Ausnehmung 40 des Trägerelements 18 in z-Richtung fortsetzt. An dem hier lediglich gezeigten einzelnen Steg 50 soll verdeutlicht werden, dass durch eine zu der Stufe 44 passende Formgebung der Stege des Zwischenelements eine erhöhte Verbindungsfläche geschaffen wird, und dass neben der stirnseitigen Verbindungsfläche (senkrecht zur z-Richtung) auch eine seitliche Verbindungsfläche (parallel zur z-Richtung) geschaffen wird, was die Druckfestigkeit des insgesamt gebildeten Medienkanals wesentlich erhöht.

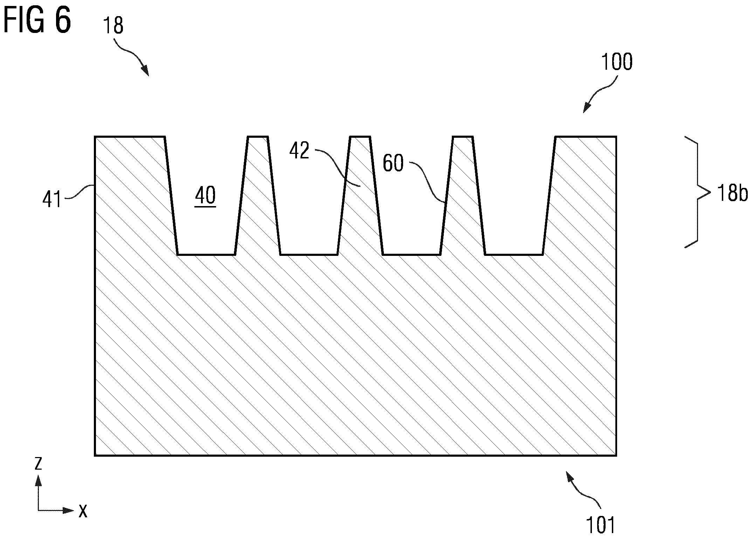

Beim Beispiel der Figur 6 weisen die Stege 42 jeweils schräge Seitenwände 60 auf, die also einen von Null verschiedenen Winkel mit der z-Richtung einschließen. Entsprechend weisen die ausgebildeten Kanalsegmente der kanalförmigen Ausnehmung 40 jeweils einen trapezförmigen Querschnitt auf. Ein solcher trapezförmiger Querschnitt, der sich zu einer Außenseite des Trägerelements 18 hin vergrößert, kann mit einem Prägeverfahren besonders leicht gebildet werden. Eine solche schräge Ausgestaltung der Seitenwände 60 ist auch vorteilhaft, um einen Verschleiß des Prägewerkzeugs insgesamt gering zu halten.

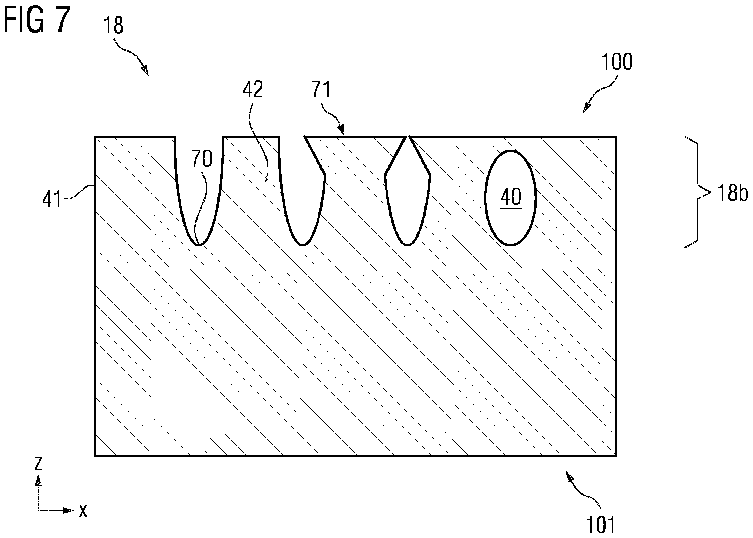

Figur 7 zeigt beispielhaft vier nebeneinanderliegende Kanalsegmente der kanalförmigen Ausnehmung 40, die jeweils auf der Innenseite des Medienkanals einen abgerundeten Boden 70 aufweisen. Dabei kann die ganz links dargestellte, nach oben offene Kanalform leicht durch ein entsprechend geformtes Prägewerkzeug in einem einzelnen Prägeschritt ausgebildet werden. Ein gerundeter Boden 70 ist allgemein vorteilhaft, da möglichst runde Kanalquerschnitte sich günstig auf das Fließen des Arbeitsmediums im pulsierenden Betrieb auswirken. So können Strömungsabrisse vermieden werden, und die Trennung in flüssige und gasförmige Mediensegmente kann aufrechterhalten werden. Bei den rechten drei Kanalsegmenten ist die kanalförmige Ausnehmung dagegen auch zur Oberseite 100 hin verengt. Eine solche Verengung kann insbesondere durch ein nach dem Prägeschritt ausgeführtes Stauchen der Oberseite erfolgen, indem also erneut ein Verformungswerkzeug auf die Oberseite 100 des Trägerelements 18 gedrückt wird. Beispielhaft ist für den mittleren Steg 42 ein entsprechend gestauchter Bereich 71 gezeigt, in dem sich die Stegbreite nach außen hin vergrößert. Vom Medienkanal aus betrachtet ergibt sich durch diese Stauchung eine überhängende Struktur, die mit einem einzelnen Prägeschritt nicht erreichbar ist, sondern nur durch eine auf den Prägeschritt folgende zusätzliche Stauchung. Beim zweiten Kanalsegment von rechts ist die Stauchung der Stegoberseite so stark, dass das Kanalsegment zur Oberseite 100 fast geschlossen ist. Das ganz rechte Kanalsegment ist durch die Stauchung sogar zur Oberseite hin ganz geschlossen, und es ergibt sich auch auf dieser Seite eine annähernd runde Querschnittsform. Auch wenn eine perfekte Rundung oder gar ein kreisförmiger Querschnitt durch eine Kombination aus Prägen und anschließendem Stauchen der Stege nur schwer zu erreichen ist, so kann eine gerundete und/oder nach oben hin angeschrägte Querschnittsform der Kanalsegmente jedoch allgemein vorteilhaft für den pulsierenden Fluidtransport im Innenraum des Wärmerohrs sein. Die vier unterschiedlichen Geometrien der nebeneinanderliegenden Kanalsegmente der Figur 7 sind nur beispielhaft zu verstehen und sollen die Variationsbreite der möglichen Formen illustrieren. In einem realen Trägerelement ist es jedoch vorteilhaft, wenn die parallel zueinander verlaufenden Kanalsegmente untereinander eine gleiche oder zumindest ähnliche Querschnittsform und/oder Querschnittsgröße aufweisen.

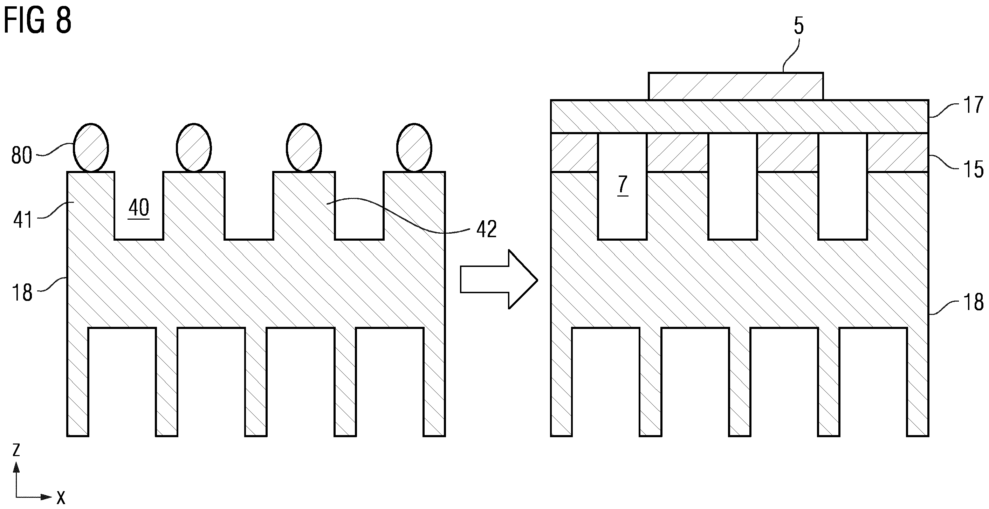

Figur 8 zeigt ein ähnliches Trägerelement 18, welches wie oben beschrieben durch einen Prägeschritt (und optional weitere Verfahrensschritte) mit einer kanalförmigen Ausnehmung 40 für den Medienkanal 7 versehen wurde. In dieser Figur ist schematisch ein nachfolgender Verfahrensschritt gezeigt, in welchem dieses Trägerelement 18 auf seiner Oberseite über ein schichtartiges Zwischenelement 15 mit einem Deckelement 17 verbunden wird, um insgesamt einen Medienkanal 7 in dem so gebildeten Schichtsystem auszubilden. Das Material 80 des Zwischenelements 15 wird in diesem Beispiel durch ein additives Fertigungsverfahren auf die obenliegenden Stirnseiten der Stege 42 und auch der Randbereiche 41 aufgebracht, wie im linken Teil der Figur 8 angedeutet. Im rechten Teil der Figur 8 ist ein Prozessstadium gezeigt, in dem diese Materialraupen 80 mit einem vorgefertigten Deckelement 17 stoffschlüssig verbunden wurden, beispielsweise durch Schmelzen des Materials 80. Bei einem solchen Schmelzvorgang kann in z-Richtung ein Druck auf den Schichtstapel ausgeübt werden, so dass insgesamt eine dauerhafte stoffschlüssige Verbindung zwischen dem Schichtsystem der Elemente 18, 15 und 17 ausgebildet wird. Alternativ zu einer solchen in-situ-Herstellung des Zwischenelements 15 kann dieses Zwischenelement auch durch ein vorgefertigtes Bauteil oder durch eine Mehrzahl von ineinandergelegten vorgefertigten Bauteilen gebildet sein. Ähnlich wie die Elemente 15 und 16 in der Figur 2 können mehrere solche Zwischenelemente innerhalb derselben vertikalen Schicht ineinandergelegt sein, um zusammen eine Aussparung für den innenliegenden Medienkanal 7 zu bilden. Die entsprechenden flächigen, strukturierten Platten für diese vorgefertigten Zwischenelemente 15 bzw. 16 können beispielsweise durch einen

Stanzprozess strukturiert werden, insbesondere wenn die Ausnehmungen in solchen Zwischenelementen in z-Richtung durchgehend sind.

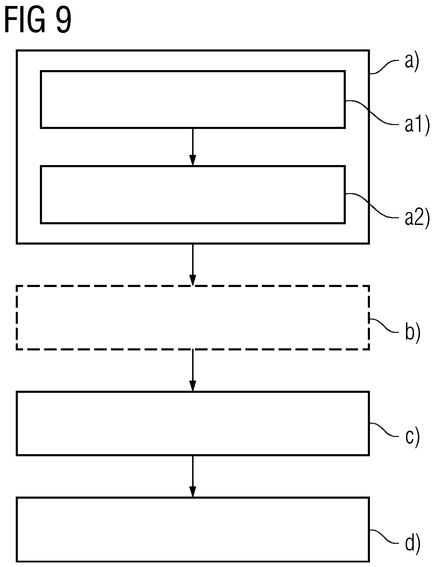

In Figur 9 ist eine schematische Abfolge von ausgewählten Schritten eines Herstellungsverfahrens für ein entsprechendes Wärmerohr 3 nach einem Ausführungsbeispiel der Erfindung gezeigt. In Schritt a) des Verfahrens wird eine kanalförmige Ausnehmung 40 in einem Trägerelement 18 des Wärmerohrs gebildet. Dieser Schritt a) kann insgesamt aus mehreren Teilschritten a1), a2) und optional noch weiteren Teilschritten bestehen. Wesentlich ist, dass wenigstens einer dieser Teilschritte ein Prägeschritt ist. Es können insgesamt mehrere Prägeschritte zum Einsatz kommen, und auch die Kombination mit anderen Prozessarten wie z.B. einem Frässchritt ist möglich. So kann insgesamt mit vergleichsweise geringem Aufwand eine komplexe kanalförmige Ausnehmung gebildet werden, wobei auch die Querschnittsform der Kanalsegmente gezielt eingestellt werden kann, wie im Zusammenhang mit den Figuren 6 und 7 beschrieben. Außerdem kann eine gewünschte Form der Stirnseite der Stege erzielt werden, wie im Zusammenhang mit den Figuren 4 und 5 beschrieben. Im nachfolgenden Schritt b) wird das so geformte Trägerelement 18 mit einem oder mehreren Zwischenelementen 15 bzw. 16 verbunden. Dieser Schritt ist jedoch allgemein optional, wie durch die gestrichelte Linie angedeutet. Im nachfolgenden Schritt c) wird der Medienkanal zur Oberseite hin mit einem Deckelement 17 verschlossen. Wenn Schritt b) ausgeführt wurde und wenigstens ein Zwischenelement vorliegt, wird das Deckelement mit dem Zwischenelement verbunden. Wenn kein Zwischenelement vorhanden ist, wird das Deckelement direkt mit dem Trägerelement verbunden. Im nachfolgenden Schritt d) ist das Befüllen und Verschließen des Innenraums des so gebildeten Wärmerohrs zusammengefasst. Schritt d) kann insbesondere die Teilschritte des Evakuierens, des Befüllens mit einem Arbeitsmedium 9 und des Verschließens einer Befüllungsöffnung 19 umfassen. In einem nachfolgenden und hier nicht näher dargestellten Schritt kann das so gebildete Wärmerohr 3 mit einem elektronischen Bauelement 5 verbunden werden, um insgesamt ein Elektronikmodul gemäß der vorliegenden Erfindung auszubilden.

### Bezugszeichenliste

- 1: Elektronikmodul
- 3: Wärmerohr (PHP)
- 5: Bauelement (Halbleiterchip)
- 7: Innenraum (Medienkanal)
- 9: Arbeitsmedium
- 11: Dampfsegment
- 13: Flüssigkeitssegment
- 15: Zwischenelement (Isolationselement)
- 16: Zwischenelement (Isolationselement)
- 17: Deckelement
- 18: Trägerelement (Kühlkörper)
- 18a: oberflächenvergrößernde Struktur (Kühlrippen)
- 18b: Relief
- 19: Befüllungsöffnung
- 20: Lotverbindung
- 21: Füllmaterial
- 30: Prägewerkzeug (Prägestempel)
- 40: kanalförmige Ausnehmung
- 41: Randbereich
- 42: Steg
- 43: Einprägung (Einkerbung)
- 44: Stufe
- 50: Steg des Zwischenelements
- 60: Seitenwand
- 70: Boden
- 71: Stegoberseite (gestauchter Bereich)
- 80: Material des Zwischenelements
- 100: Oberseite
- 101: Unterseite
- C: Kondensatorbereich
- E: Verdampferbereich
- p: Prägedruck (Anpressdruck)
- x,y: laterale Richtungen
- z: vertikale Richtung

## Patentansprüche

1. Verfahren zum Herstellen eines Wärmerohrs (3) mit einem geschlossenen Innenraum (7) zum Transport eines fluiden Arbeitsmediums (9), insbesondere in einem selbständig pulsierenden Betrieb,
wobei der Innenraum (7) wenigstens durch ein flächiges Trägerelement (18) und ein dem Trägerelement (18) gegenüberliegendes flächiges Deckelement (17) begrenzt ist,
wobei der Innenraum (7) zumindest teilweise durch eine kanalförmige Ausnehmung (40) des Trägerelements (18) und/oder Deckelements (17) definiert ist,
wobei die kanalförmige Ausnehmung (40) zumindest teilweise durch Anwendung eines Prägeschritts auf einen Rohling des Trägerelements (18) und/oder einen Rohling des Deckelements ausgebildet wird, und wobei nach dem Ausbilden der Ausnehmung (40) das Trägerelement (18) mit dem Deckelement (17) verbunden wird.

2. Verfahren nach Anspruch 1, bei welchem das Trägerelement (18) als Kühlkörper ausbildet, und auf einer von dem Innenraum (7) abgewandten Seite eine im Vergleich zu einer ebenen Oberfläche oberflächenvergrößernde Struktur (18a) aufweist, insbesondere eine Mehrzahl von Kühlrippen.

3. Verfahren nach einem der Ansprüche 1 oder 2, bei welchem das Wärmerohr (3) zwischen dem Trägerelement (18) und dem Deckelement (17) ein flächiges Isolationselement (15,15) aus einem elektrisch isolierenden Material (80) aufweist.

4. Verfahren nach einem der vorhergehenden Ansprüche, wobei bei dem Prägeschritt wenigstens ein Prägestempel (30) oder eine Prägerolle als Prägewerkzeug verwendet wird.

5. Verfahren nach Anspruch 4, bei welchem innerhalb des Prägeschritts das Prägewerkzeug (30) mit dem Trägerelement (18) und/oder Deckelement (17) auf einer Kontaktfläche in Berührung tritt, welche kleiner ist als die dem Prägewerkzeug (30) zugewandte Hauptfläche (100) des Trägerelements (18) und/oder Deckelements (17).

6. Verfahren nach einem der vorhergehenden Ansprüche, bei welchem zusätzlich zu dem Prägeschritt ein weiterer Verfahrensschritt mit einem von einem Prägeverfahren unterschiedlichen Verformungsverfahren und/oder subtraktiven Verfahren bei der Ausbildung der kanalförmigen Ausnehmung (40) des Trägerelements (18) und/oder Deckelements (17) zum Einsatz kommt.

7. Verfahren nach einem der vorhergehenden Ansprüche, bei welchem mehrere sequenzielle Prägeschritte bei der Ausbildung der kanalförmigen Ausnehmung (40) des Trägerelements (18) und/oder Deckelements (17) zum Einsatz kommen.

8. Verfahren nach einem der vorhergehenden Ansprüche, bei welchem die kanalförmige Ausnehmung (40) des Trägerelements (18) und/oder Deckelements (17) zumindest in Teilbereichen einen trapezförmigen Kanalquerschnitt aufweist.

9. Verfahren nach einem der vorhergehenden Ansprüche, bei welchem die kanalförmige Ausnehmung (40) des Trägerelements (18) und/oder Deckelements (17) zumindest in Teilbereichen einen abgerundeten Boden (70) aufweist.

10. Verfahren nach einem der vorhergehenden Ansprüche, bei welchem der Innenraum (7) eine Mehrzahl von mäanderförmigen Windungen aufweist und durch eine Mehrzahl von zwischen den Windungen liegenden Stegen (42) begrenzt ist.

11. Verfahren nach Anspruch 10, bei welchem im Anschluss an den Prägeschritt oder während des Prägeschritts zumindest ein Teil der Stege (42) gestaucht wird, insbesondere in einer Richtung (z) orthogonal zu einer Hauptfläche (100) des Trägerelements (18) und/oder Deckelements (17).

12. Verfahren nach einem der Ansprüche 10 oder 11, bei welchem eine Kavität im Trägerelement ausgebildet wird, wobei zumindest ein Teil der Stege (42) auf einer dem Deckelement (17) zugewandten Seite (100) mit einer Einkerbung (43) versehen wird.

13. Verfahren nach einem der Ansprüche 10 bis 12, bei welchem eine Kavität im Trägerelement ausgebildet wird, wobei zumindest ein Teil der Stege (42) auf einer dem Deckelement (17) zugewandten Seite (100) gestuft geformt ist.

14. Wärmerohr (PHP) mit einem geschlossenen Innenraum (7) zum Transport eines fluiden Arbeitsmediums (9), insbesondere in einem selbständig pulsierenden Betrieb,
wobei der Innenraum (7) wenigstens durch ein flächiges Trägerelement (18) und ein dem Trägerelement (18) gegenüberliegendes flächiges Deckelement (17) begrenzt ist,
wobei der Innenraum (7) zumindest teilweise durch eine kanalförmige Ausnehmung (40) des Trägerelements (18) und/oder des Deckelements (17) definiert ist,
wobei das Wärmerohr (3) mit einem Verfahren nach einem der Ansprüche 1 bis 13 hergestellt ist.

15. Elektronikmodul (1) mit wenigstens einem elektronischen Bauelement (5) und einem Wärmerohr (3) nach Anspruch 14 zur Entwärmung des elektronischen Bauelements (5).
